# EUROPEAN PATENT APPLICATION

(11) **EP 4 075 415 A1**
(43) Date of publication of application: **19.10.2022**
(21) Application number: 20900617.0
(22) Date of filing: 09.12.2020
(51) Int. Cl.: G09F 9/30

(54) **ELECTRONIC APPARATUS**

(30) Priority: 13.12.2019 CN 201911283433
(71) Applicant: GUANGDONG OPPO MOBILE TELECOMMUNICATIONS CORP., LTD., Dongguan, Guangdong 523860 (CN)
(72) Inventor: YIN, Bin, Dongguan, Guangdong 523860 (CN)
(74) Representative: Manitz Finsterwald Patent- und Rechtsanwaltspartnerschaft mbB
(86) International application number: PCT/CN2020/134962
(87) International publication number: WO 2021/115334

(57) **Abstract**

An electronic apparatus (100). The electronic apparatus (100) comprises a housing (10), a reel (20), and a flexible display screen assembly (30). The housing (10) comprises a first portion (12) and a second portion (14) which are capable of moving relatively. The reel (20) is provided at the first portion (12). The flexible display screen assembly (30) comprises a flexible display screen (32) and a flexible supporting member (34) which is stacked and fixedly connected to the flexible display screen (32), the flexible display screen (32) is connected to the second portion (14), the flexible supporting member (34) is wound on the reel (20) and fixedly connected to the flexible display screen (32), and when the first portion (12) and the second portion (14) move away from each other, the reel (20) can rotate to release the flexible supporting member (34) of the flexible display screen assembly (30) so as to expand a display portion (301) of the flexible display screen (32). When the first portion (12) and the second portion (14) move away from each other, the flexible supporting member (34) abuts against the first portion (12) to maintain the expanded portion of the flexible display screen (32) flat.

## Description

### PRIORITY INFORMATION

The present application claims priority to Chinese Patent Application No. 201911283433.1 filed with China National Intellectual Property Administration on December 13, 2019, the contents of which are herein incorporated by reference in their entireties.

### TECHNICAL FIELD

The present disclosure relates to a field of electronic technology, in particular to an electronic apparatus.

### BACK GROUND

At present, users use mobile terminals more and more frequently, and usage scenarios are becoming increasingly diversified. Now most portable smart mobile terminals have small screen sizes, usually under 7 inches. Compared with products such as tablets, the screen display area of the portable smart mobile terminals is limited and the operation experience is limited. However, with respect to a mobile terminal with a larger screen size, for example, a mobile terminal larger than 7 inches, although the screen size is increased, the overall size of the mobile terminal is larger, which is not easy to carry.

### SUMMARY

An embodiment of the present disclosure provides an electronic apparatus.

The electronic apparatus includes:
a housing, including a first portion and a second portion which are capable of moving relative to each other;
a reel, arranged on the first portion; and
a flexible display screen assembly, including a flexible display screen and a flexible supporting member stacked and fixedly connected to the flexible display screen; the flexible display screen, connected to the second portion, the flexible supporting member, wound around the reel and fixedly connected to the flexible display screen, in response to the first portion and the second portion moving away from each other, the reel is capable of rotating to release the flexible supporting member to expand a display portion of the flexible display screen;
in response to the first portion and the second portion moving away from each other, the flexible supporting member abuts against the first portion to maintain an expanded portion of the flexible display screen flat.

The additional aspects and advantages of the embodiments of the present disclosure will be partly given in the following description, and part of them will become obvious from the following description, or be understood through the practice of the embodiments of the present disclosure.

### BRIEF DISCRIPTION OF THE DRAWINGS

The above and/or additional aspects and advantages of the present application will become obvious and easy to understand from the description of the embodiments in conjunction with the following drawings.
FIG. 1 is a structural schematic view of a state of an electronic apparatus according to an embodiment of the present disclosure.
FIG. 2 is a structural schematic view of another state of an electronic apparatus according to an embodiment of the present disclosure.
FIG. 3 is an exploded structural schematic view of an electronic apparatus according to an embodiment of the present disclosure.
FIG. 4 is a schematic plan view of an electronic apparatus according to an embodiment of the present disclosure.
FIG. 5 is a cross-sectional structural schematic view of the electronic apparatus along V-V direction in FIG. 4.
FIG. 6 is a structural schematic plan view of an electronic apparatus according to another embodiment of the present disclosure.
FIG. 7 is a cross-sectional structural schematic view of the electronic apparatus along VII-VII direction in FIG. 6.
FIG. 8 is a partial structural schematic view of an electronic apparatus according to an embodiment of the present disclosure.
FIG. 9 is a structural schematic view of a second portion of a housing of an electronic apparatus according to an embodiment of the present disclosure.
FIG. 10 is a structural schematic view of a second portion of a housing of an electronic apparatus according to another embodiment of the present disclosure.
FIG. 11 is a structural schematic view of an electronic apparatus according to another embodiment of the present disclosure.
FIG. 12 is a structural schematic view of an electronic apparatus according to another embodiment of the present disclosure.
FIG. 13 is a structural schematic view of an electronic apparatus according to another embodiment of the present disclosure.
FIG. 14 is a structural schematic view of an electronic apparatus according to another embodiment of the present disclosure.
FIG. 15 is a cross-sectional structural schematic view of an electronic apparatus according to another embodiment of the present disclosure.
FIG. 16 is a cross-sectional structural schematic view of an electronic apparatus according to another embodiment of the present disclosure.
FIG. 17 is a cross-sectional structural schematic view of an electronic apparatus according to another embodiment of the present disclosure.
FIG. 18 is a cross-sectional structural schematic view of an electronic apparatus according to another embodiment of the present disclosure.
FIG. 19 is a structural schematic view of a restoring mechanism of an electronic apparatus according to an embodiment of the present disclosure.
FIG. 20 is a cross-sectional structural schematic view of a locking structure of an electronic apparatus according to an embodiment of the present disclosure.
FIG. 21 is a cross-sectional structural schematic view of a locking structure of an electronic apparatus according to another embodiment of the present disclosure.

### DETAILED DESCRIPTION

Embodiments of the present disclosure will be further described in conjunction with drawings below. Same or similar labeling in the drawings always indicate element with same or similar structure or elements with same or similar function.

In addition, the embodiments of the present disclosure in conjunction with drawings are exemplary, which is configured to explain but not limiting the present disclosure.

Different embodiments or examples are provided below to achieve different structure in the present disclosure. In order to simplify the present disclosure, components and setting of specific examples will be described below. Of course, the components and settings of specific examples are examples, but not configured to limit the present disclosure. In addition, reusing reference numbers and/or letters in different examples is for the purpose of simplification and clarity, and does not indicate the relationship between the various embodiments and/or settings discussed.

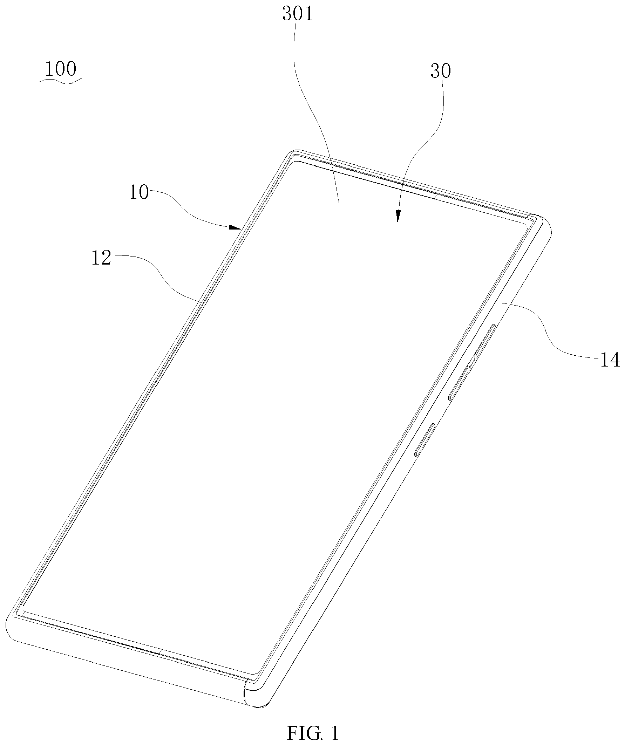

As shown in FIG. 1 to FIG. 3, in some embodiments of the present disclosure, an electronic apparatus 100 includes a housing 10, a reel 20, a flexible display screen assembly 30, a limiter 40, a cover 50, a camera 60, a mainboard (not shown), and a driving mechanism 70. The reel 20, the flexible display screen assembly 30, the limiter 40, the cover 50, the camera 60, the mainboard, and the driving mechanism 70 may be positioned on the housing 10. It is understandable that, the electronic apparatus in the embodiments of the present disclosure includes but is not limited to mobile terminals such as mobile phones and tablets or other portable electronic devices. In the present disclosure, a mobile phone will be described as an example for the electronic apparatus 100.

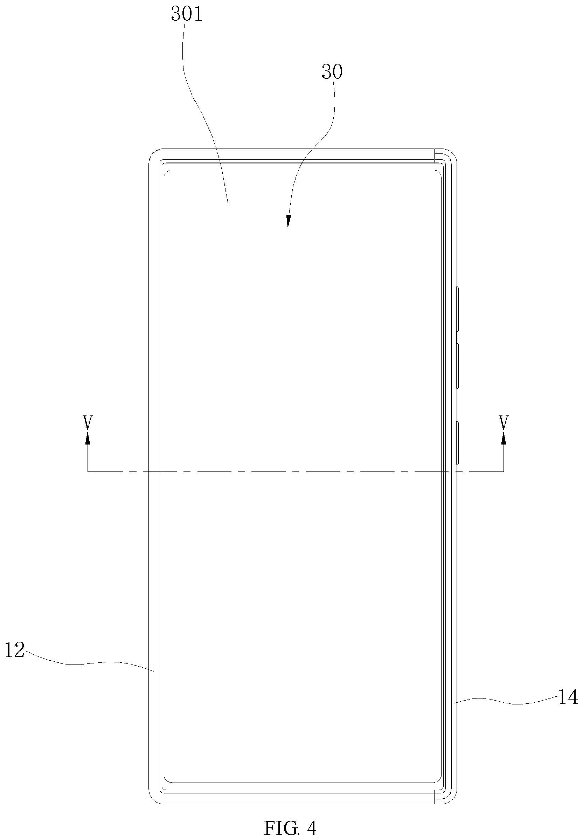

As shown in FIG. 4 to FIG. 7, in some embodiments, the housing 10 includes a first portion 12 and a second portion 14, the first portion 12 and the second portion 14 may move away from each other. Specifically, the first portion 12 and the second portion 14 are slidably connected to each other, i.e., the second portion 14 may slide relative to the first portion 12.

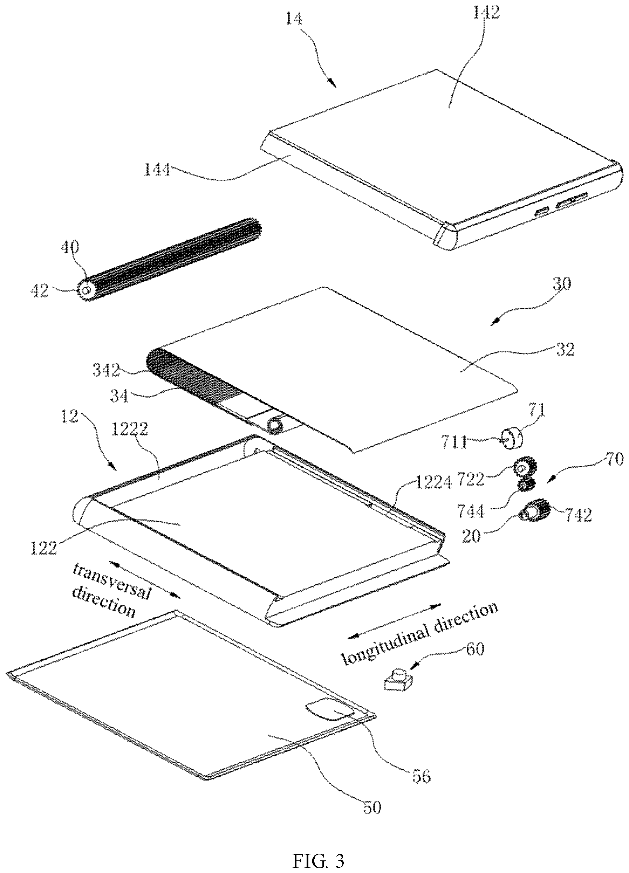

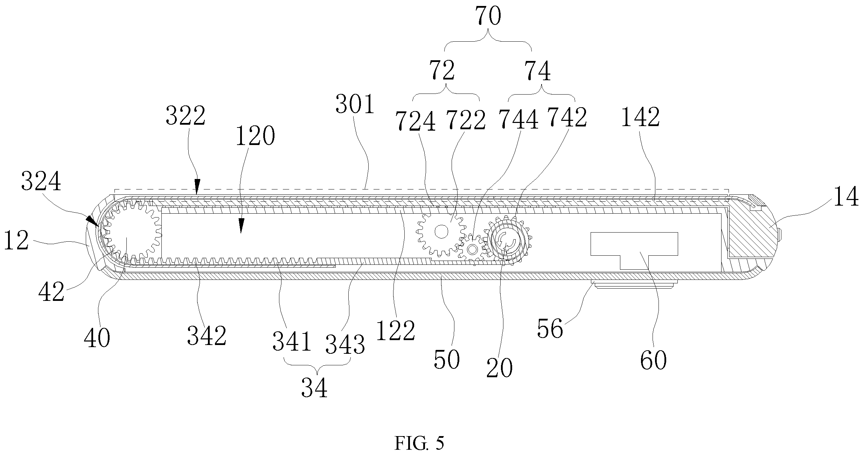

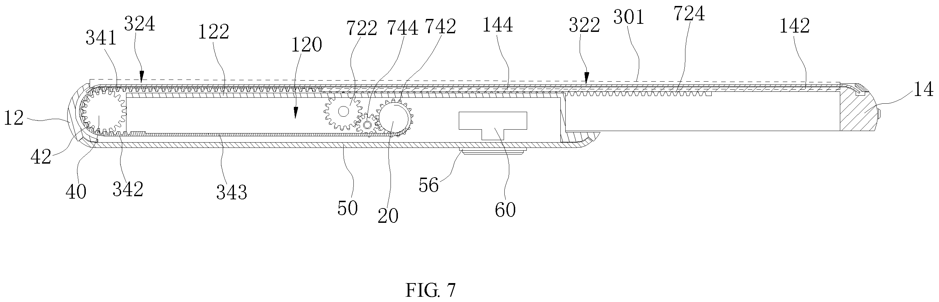

As shown in FIG. 3, FIG. 5. and FIG. 7, the first portion 12 is rectangular, the first portion 12 defines an accommodating space 120, a bottom of the accommodating space 120 is open. The accommodating space 120 may be provided with the reel 20, the limiter 40, the camera 60, mainboard, and drive mechanism 70, etc. Of course, the accommodating space 120 may be stacked with other electrical components such as a vice-board, a sensor, and a battery, etc.

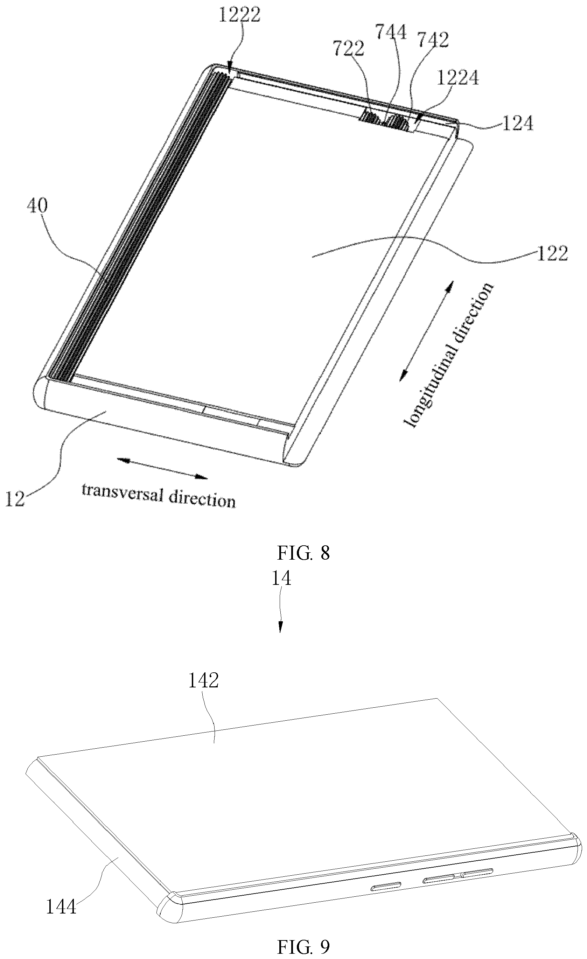

As shown in FIG. 3 and FIG. 8, the first portion 12 includes a first top plate 122 which defines a first opening 1222 and a second opening 1224, the first opening 1222 and the second opening 1224 communicates with the accommodating space 120. A direction of the first opening 1222 is perpendicular to a direction of the second opening 1224. The first opening 1222 is configured to be pass through by another end of the flexible display screen assembly 30 to connect to an end of the reel 20, the second opening 1224 is configured to expose the drive mechanism 70 from the accommodating space 120 to connect to a second portion 14.

The number of the second opening 1224 is two, the second opening 1224 is located at symmetrical two side of the first top plate 122. Specifically, as shown in FIG. 3 and FIG. 8, in some embodiments, the first opening 1222 may be along a sliding direction of the second portion 14, i.e., opened along a longitudinal direction of the electronic apparatus 100. The second opening may be along a direction perpendicular to the sliding direction of the second portion 14, i.e., opened along a transversal direction of the electronic apparatus 100, the second portion 14 may move along the transversal direction of the electronic apparatus 100 relative to the first portion 12. In addition, the first portion 12 define a sliding groove 124 which is configured to cooperate with the second portion 14 to make the second portion 14 slide relative to the first portion 12.

In the present disclosure, it should be noted that it should be understood that, unless otherwise clearly specified and limited, terms such as "center", "longitudinal", "transverse", "length", "width", "thickness", "upper", "lower", "vertical", "horizontal", "top", "bottom", "inner", and "outer" indicate an orientation or a relationship of position which is based on the drawings. The terms are configured to be easy to describe the present disclosure but not limiting the resent disclosure. In addition, terms such as "first" and "second" are used for the purpose of description but not indicating or implying relative importance or implicitly indicating the number of indicated technical features. Therefore, the features defined with "first" and "second" may explicitly or implicitly include one or more of the features. In the description of the present application, "multiple" means two or more than two, unless otherwise specifically defined.

As shown in FIG. 3, FIG. 5, and FIG. 7, the second portion 14 is located on the first portion 12, the second portion 14 is substantially cuboid-shaped, the second portion 14 includes a sliding portion 144, and a second top plate 142. The sliding portion 144 is connected to longitudinal two sides of the second top plate 142, and the sliding portion 144 is arranged substantially symmetrically. The sliding portion 144 is configured to cooperate with the sliding groove 124 of the first portion 12 to realize a sliding connection between the first portion 12 and the second portion 14. The second portion 14 is arranged according to the first portion 12, and the second portion 14 is attached to the first portion 12. It should be noted that, the attachment in the disclosure may be understood as the contact between two objects but does not affect the slide between the two objects, or it can be understood that the gap between the two objects falls within the assembly error scope.

In the present disclosure, it should be pointed out that a structure in which a first feature is "on" or "below" a second feature may include an embodiment in which the first feature is in direct contact with the second feature, and may also include an embodiment in which the first feature and the second feature are not in direct contact with each other, but are contacted via an additional feature formed therebetween. In addition, a structure in which the first feature "on", "above" or "on top of' a second feature may include an embodiment in which the first feature is right or obliquely "on", "above" or "on top of' the second feature, or just means that the first feature is at a height higher than that of the second feature; while a first feature "below", "under" or "on bottom of' a second feature may include an embodiment in which the first feature is right or obliquely "below", "under" or "on bottom of' the second feature, or just means that the first feature is at a height lower than that of the second feature.

In the embodiments, it may be understood that the second portion 14 may slide relative to the first portion 12 to move close to or move away from the first portion 12. In the embodiments, "the first portion 12 moves away from the second portion 14" may be understood that the second portion 14 slides relative to the first portion 12, and the sliding direction is away from the first portion 12. In addition, in the embodiments, the first portion 12 and the second portion 14 may move toward each other, which may be understood that the second portion 14 slides relative to the first portion 12, and the sliding direction is toward the first portion 12.

In the present disclosure, it should also be noted that it should be pointed out that, unless otherwise clearly specified and limited, the terms "mounted", "connected" and the like are understood more broadly, and may be, for example, fixed connections, detachable connections, or integral connections; may also be mechanical or directed connections; may also be indirect connections via intervening structures; may also be inner communications of two components; may also be interaction relationship between two components, which can be understood by those skilled in the art according to specific situations.

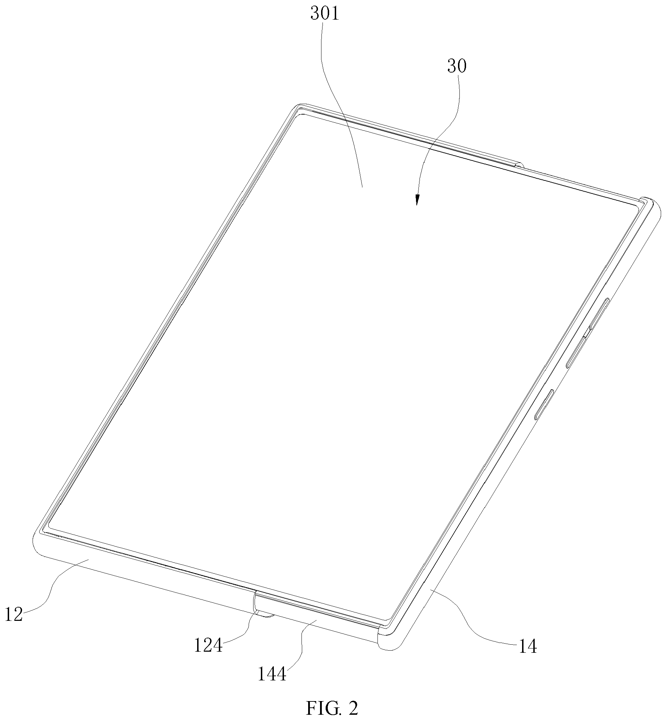

As shown in FIG. 1, FIG. 4, and FIG. 5, in some embodiments, in response to the first portion 12 moving toward a first extreme position relative to the second portion 14 (i.e., the first portion 12 moves close to the second portion 14 and the first portion 12 combines with the second portion 14), the first portion 12 and the second portion 14 forms a substantially cuboid-shaped cover. As shown in FIG. 2, FIG. 6, and FIG. 7, the first portion 12 and the second portion 14 may move away from each other (i.e., they are stay away from each other), the first portion 12 and the second portion 14 are separated from each other.

Referring to FIG. 3, FIG. 5, and FIG. 7, the reel 20 is rotatably arranged at the first portion 12, specifically, the reel 20 is rotatably arranged in the accommodating space 120. That is, the reel 20 is arranged at the first portion 12 and may be rotated relative to the first portion 12. The reel 20 is configured to connect to the drive mechanism 70, such that the reel 20 may be rotated relative to the first portion 12 driven by the drive mechanism 70 to release or roll up flexible display screen assembly 30.

It should be understood that the reel 20 is rotatably arranged at the first portion 12, which is indicated that the reel 20 is directly arranged at the first portion 12. In some embodiments, the reel 20 is arranged at the first portion 12 through other medium.

In addition, as shown in FIG. 5 to FIG. 7, an end of the flexible display screen assembly 30 is fixedly connected to the second portion 14, and another end of the flexible display screen assembly 30 is wound around the reel 20. The reel 20 may be configured to roll up or release the flexible display screen assembly 30. In response to the first portion 12 and the second portion 14 moving away from each other, the reel 20 may be rotated to release the flexible display screen assembly 30, thereby expanding a display portion 301 of a flexible display screen 32. Specifically, the end of the flexible display screen assembly 30 is fixedly connected to the second portion 14, another end is connected to the reel 20 arranged in the accommodating space 120 after passing through the first opening 1222 of the first portion 12.

Therefore, in response to the first portion 12 and the second portion 14 moving away from each other, the reel 20 may be rotated to release the flexible display screen assembly 30, thereby expanding the display portion 301 of the flexible display screen 32. Therefore, a screen display region of the electronic apparatus 100 may be freely adjusted, such that the display portion 301 of the flexible display screen 32 may be expanded in response to a large screen being in need, thereby improving an experience of users. In addition, in response to the large screen being not in need, the display screen 301 may not be expanded, such that the complete electronic apparatus is small and easy to take along.

As shown in FIG. 5, it should be understood that, in one case, the first portion 12 and the second portion 14 is close to connected to each other, the display portion 301 of the flexible display screen 32 is not expanded, and the electronic apparatus 100 is in a narrow screen model, a part of the flexible display screen assembly 30 is roll up on the reel 20, another part of the flexible display screen assembly 30 is located above the first top plate 122 and exposed from the housing 10 to display. In some embodiments, it should be indicated that the display portion 301 of the flexible display screen 32 may be a part located on the second top plate 142 of the second 14, i.e., a part exposed from the housing 10 to display.

As shown in FIG. 7, in response to the display portion 301 of the flexible display screen 32 being in need, the first portion 12 and the second portion 14 move away from each other, such that the second portion 14 put an end of the flexible display screen assembly 30 in motion, and the reel 20 may release a flexible supporting member 34 of the flexible display screen assembly 30 so as to enlarge the display portion 301 of the flexible display screen 32, thereby improving operation experience of the users and satisfying requirement of the users. In this case, the electronic apparatus is in a state of expanded model.

It should be understood that, the second portion 14 and the first portion 12 may move to a second extreme position in response to they moving away from each other. The screen display region of the electronic apparatus 100 is largest in response to the second portion 14 and the first portion 12 being located at the second extreme position, i.e., the exposed region of the flexible display screen 32 from the housing 10 is largest, and the display portion 301 of the flexible display screen 32 is largest (as shown in FIG. 7). In response to the first portion 12 and the second portion 14 moving toward and connect to and combine with each other, the screen display region of the electronic apparatus 100 is smallest, i.e., the exposed region of the flexible display screen 32 from the housing 10 is smallest, and the display portion 301 of the flexible display screen 32 is smallest (as shown in FIG. 5).

The end of the flexible display screen assembly 30 is fixedly connected to the second portion 14, which indicated that the end of the flexible display screen assembly 30 is directly fixedly connected to the second portion 14. In some embodiments, the end of the flexible display screen assembly 30 is fixedly connected to the second portion 14 through other medium. The end of the flexible display screen assembly 30 can not move relative to the second portion 14.

In the embodiments of the present disclosure, the end of the flexible display screen assembly 30 is a first edge of the end of the flexible display screen assembly 30, another end of the flexible display screen assembly 30 is a second edge of the flexible display screen assembly 30. The first edge and the second edge are arranged opposite to each other.

Specifically, as shown in FIG. 3, FIG. 5 and FIG. 7, the flexible display screen assembly 30 includes the flexible display screen 32 and the flexible display screen 34, and the flexible display screen 32 and the flexible supporting member 34 are stacked with and fixedly connected to each other, the flexible display screen 32 is connected to the second portion 14, the flexible supporting member 34 is wound on the reel 20 and fixedly connected to the flexible display screen 32.

Specifically, the flexible display screen 32 includes a first region 322 fixedly connected to the second top plate and a second region 324 connected to the first region 322. The first region 322 is arranged corresponding to the second top plate 142 and attached to the second top plate 142.

At least a part of the second region 324 is located in the accommodating space 120 of the first portion 12 and attached to the flexible supporting member 34. The first region 322 may be fixedly connected to the second top plate 142 through an optically clear adhesive.

The flexible supporting member 34 is arranged at a bottom of the second region 324 and completely cover the second region 324. The flexible supporting member 34 may also be fixedly connected to the second region 324 through the optically clear adhesive. In the examples of FIG. 5 and FIG. 7, the flexible supporting member 34 includes a first supporting portion 341 and a second supporting portion 343, and the first supporting portion 341 is arranged corresponding to the second supporting portion 343 which is wound around the reel 20. That is, in some embodiments, the second supporting portion 343 extends from the second region 324 and wound around the reel 20. As shown in FIG. 5, in response to the electronic apparatus being in the narrow screen model, the flexible supporting member 34 is rolled up on the reel 20, a shape of the flexible display screen 32 is substantially "U" -shaped.

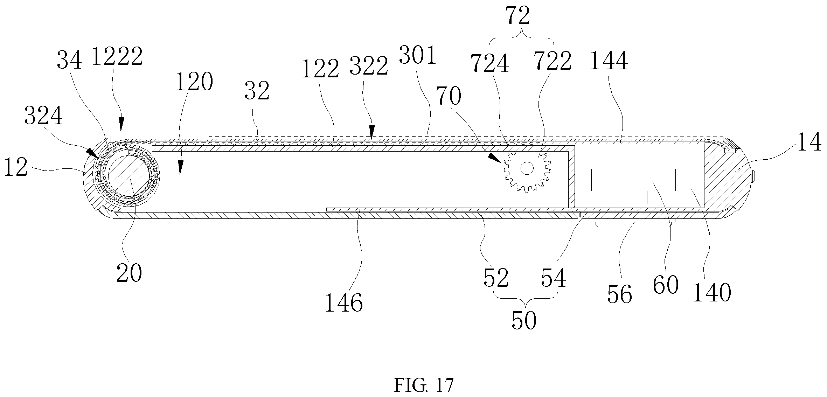

Therefore, in response to the electronic apparatus being in the narrow screen model (i.e., the first portion 12 and the second portion 14 move away from each other and move to the first extreme position), the reel 20 only rolls up the second supporting portion 343 of the flexible supporting member 34, and the flexible display screen 32 may not be rolled up by the reel 20 so as to reduce degree and frequency of bend of the flexible display screen 32, and increase service life of the flexible display screen 32. Of cause, as shown in FIG. 17, it should be understood that, in some embodiments, the flexible display screen 32 may also be arranged such that the flexible supporting member 34 correspond to the second region 325, and the flexible supporting member 34 and the flexible display screen 30 are wound around the reel 20, i.e., the reel 20 may release the flexible supporting member 34 and the flexible display screen 32 at the same time, which is not limited herein.

In addition, in some embodiments, a shape of the flexible display screen assembly 30 is substantially "U"-shaped, the mainboard, the electrical components such as the vice-board, the sensor and the battery of the electronic apparatus 100 may be received in a space surrounded by the flexible display screen assembly 30. Therefore, an arrangement of the flexible display screen assembly 30 has not impact on a setting of the electrical components such as the mainboard and the battery, thereby effectively improving a utilization rate of space, which is conductive to stack and the setting of the electrical components such as the mainboard and the battery.

As shown in FIG. 5 and FIG. 7, in some embodiments, in response to the first portion 12 and the second portion 14 moving away from each other, the flexible supporting member 34 abuts against the first portion 12 to maintain an expanded portion of the flexible display screen 32 flat.

It should be pointed out that the expanded portion is a part of the flexible display screen assembly 30 be released from the first portion 12 in response to the first portion 12 and the second portion 14 moving away from each other, i.e., an expansion part of the flexible display screen assembly 30. if there is a same or a similar description in following description, you can refer to it to understand.

Specifically, the first top plate 122 is arranged corresponding to the display portion 301 of the flexible display screen 32 and attached to the first top plate 122. In response to the first portion 12 and the second portion 14 moving away from each other, the flexible supporting member 34 is located between the flexible display screen 32 and the first top plate 122 to fill a gap between the flexible display screen 32 and the first top plate 122, i.e., a thickness of the flexible supporting member 34 is equal to a distance between an upper surface of the first portion 12 and an upper surface of the second portion 14.

As shown in FIG. 7, it should be understood that, in response to the first portion 12 and the second portion 14 moving away from each other, there is a difference of height between an upper surface of the first top plate 122 and an upper surface of the second top plate 142. The flexible display screen 32 is fixedly connected to the upper surface of the second top plate 142, such that the flexible supporting member 34 abuts against the first top plate 122 of the first portion 12, i.e., the flexible supporting member 34 fills the gap between the flexible display screen 32 and the first top plate 122. In other word, since the upper surface of the first top plate 122 is attached to a lower surface of the second top plate 142, and the flexible display screen 32 is fixedly connected to the upper surface of the second top plate 142, the thickness of the flexible supporting member 34 is equal to a thickness of the second top plate 142, which may fill the difference between the first top plate 122 and the second top plate 142, i.e., fill the gap of between the flexible display screen 32 and the first top plate, such that the expanded portion of the flexible display screen 32 may maintain flat in response to the flexible display screen 32 moving. Therefore, in response to the electronic apparatus 100 being in the state of expanded model and the flexible display screen 32 is touched, a pressing deformation, a collapse and a dislocation of the flexible display screen 32 may be reduced so as to improve the experience of the users. In addition, the flexible display screen 32 is stacked with the flexible supporting member 34, in response to the display portion 301 of the flexible display screen 32 being expanded, the flexible supporting member 34 moves with the flexible display screen 32, such that supporting area of the flexible supporting member 34 is large, thereby further preventing the flexible display screen 32 from the pressing deformation etc.

In addition, as shown in FIG. 3, FIG. 5, and FIG. 7, a bottom of the flexible supporting member 34 is provided with a first teeth portion 342 which is configured to engage with a limiter 40, such that the limiter 40 may support the flexible display screen assembly 30 and keep the flexible display screen assembly 30 moving smoothly.

In addition, in some embodiments, the flexible supporting member 34 is made of magnetic material, the flexible supporting member 34 may be attracted on the first top plate 122. Specifically, as shown in FIG. 5 and FIG. 7, in some embodiments, the first top plate 122 may also be made of magnetic material. Therefore, the flexible supporting member 34 and the first top plate 122 may attract to each other. In response to the second portion 14 and the first portion 12 moving away from each other to expand the display portion 301 of the flexible display screen 32, the flexible supporting member 34 may be attracted on the first top plate 122. It should be understood that, in some embodiments, one of the flexible supporting member 34 and the first top plate 122 has permanent magnetism, and another one may has the permanent magnetism or not.

In addition, in some embodiments, the first top plate 122 may include a supporting layer (not shown in drawings) and a magnetic layer (not shown in drawings) which is arranged on the supporting layer. In response to the second portion 14 and the first portion 12 moving away from each other to expand the display portion 301 of the flexible display screen 32, the flexible supporting member 34 may be attracted on the magnetic layer, thereby also preventing the flexible display screen assembly 30 from the dislocation and an endplay and improving the operation experience of the users in response to the electronic apparatus 100 being operated. In addition, in some embodiments, it is not necessary that the entire first top plate 122 is made of a magnetic material, but only the magnetic layer is made of a magnetic material, thereby saving manufacturing costs. It should be understood that, in some embodiments, one of the flexible supporting member 34 and the magnetic layer has permanent magnetism, and another one may has the permanent magnetism or not.

As shown in FIG. 5, FIG. 7, and FIG. 8, the limiter 40 is wound in the accommodating space 120 of the first portion 12 and exposed from the first opening 1222, a middle portion of the flexible display screen assembly 30 is wound around the limiter 40. The limiter 40 is columnar, a second teeth 42 portion is arranged on a circumference of the limiter 40, the second teeth portion 42 is configured to engage with the first teeth 342 located on the flexible supporting member 34 to support the flexible display screen assembly 30 and orientate expanding the flexible display screen assembly 30. It should be understood that the middle portion of the flexible display screen assembly 30 is a portion between two ends of the flexible display screen assembly 30.

Therefore, the limiter 40 may limit a shape of the flexible display screen assembly 30 to maintain the display portion 301 of the flexible display screen assembly 30 flat, i.e., maintain the flexible display screen assembly 30 "U"-shaped. In addition, the limiter 40 and the flexible supporting member 34 engage with each other, which may support the flexible display screen assembly 30, and orientate in response to the second portion 14 putting the flexible display screen assembly 30 in motion to keep the flexible display screen assembly 30 move smoothly.

Specifically, in some embodiments, the limiter 40 is guide gear, the limiter 40 is arranged on a position corresponding to the first opening 1222, the middle portion of the flexible display screen assembly 30 is wound around the limiter 40, the first teeth portion 342 located on the flexible supporting member 34 engages with the second teeth portion 42. That is, the end of the flexible display screen assembly 30 is fixedly connected to the second portion 14, another end passes though the first opening 1222, bypasses the limiter 40 and is connected to the reel 20. In response to the second portion 14 putting the flexible display screen 32, the limiter 40 gradually rotates driven by the flexible supporting member 34, the reel 20 gradually releases the end of the flexible supporting member 34.

It should be understood that, in some embodiments, the limiter 40 may not be provided with the second teeth portion 42, the limiter 40 may be a bare axis or a cylinder. The flexible supporting member 34 may not be provided with the first teeth portion 342, the limiter 40 and the flexible supporting member 34 are wavily connected to each other, the flexible display screen assembly 30 directly bypasses the cylinder. Therefore, the limiter 40 may also support and orientate the flexible display screen 32.

As shown in FIG. 5, FIG. 7, and FIG. 10, in some embodiments, a camera 60 may be arranged in the accommodating space 120 of the first portion 12, a cover 50 is connected to the first portion 12 and covers the accommodating 120, the camera 60 may perform an image acquisition through the cover 50. In other words, in this embodiment, the first part 12 and the cover 50 form a whole, in response to the second portion 14 moving relative to the first portion 12, the camera 60 may not follow the movement. In response to the electronic apparatus being in the state of expanded model, the camera 60 is located at a central position of the whole the flexible display screen 32.

In some embodiments, the cover 50 is removably connected to the first portion 12, such that the cover 50 may be easy to remove and repair and replace the electrical components such as the mainboard, the battery, and the sensor arranged in the accommodating space 120. It should be understood that in other embodiments, the first part 12 and the cover 50 may form the whole, they formed integrally, the specific arrangement is no limited herein.

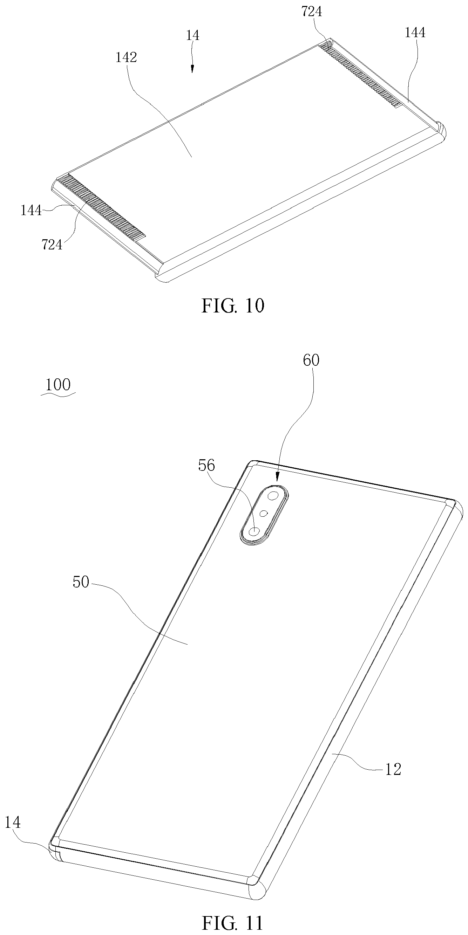

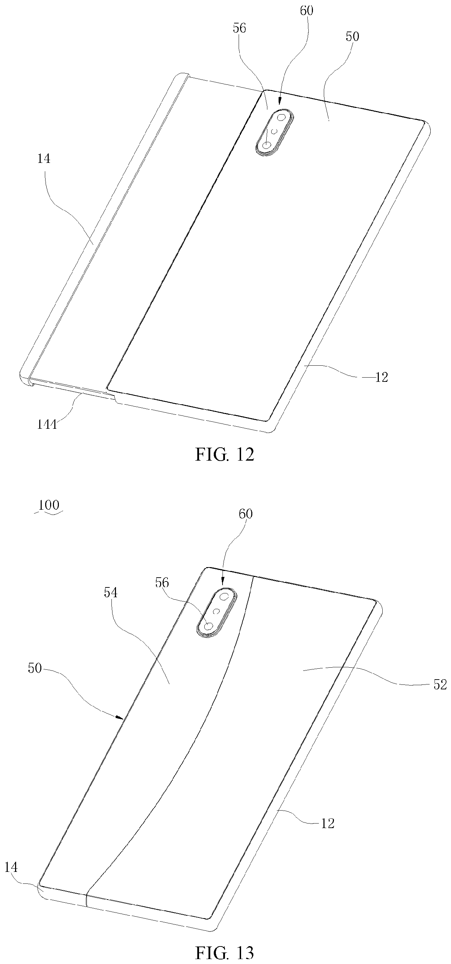

In addition, as shown in FIG. 11 and FIG. 12, a light transmission portion 56 may be arranged on the cover 50 corresponding to the position of the camera 60, a light may pass through the light transmission portion 56 and be received by the camera 60, such that the camera 60 may perform the image acquisition through the cover 50 so as to shoot outside. Therefore, the light transmission portion 56 may protect the camera 60 without interring the shooting effect of the camera 60, thereby preventing the camera 60 from being exposed from the housing 10 and being scratched by accident.

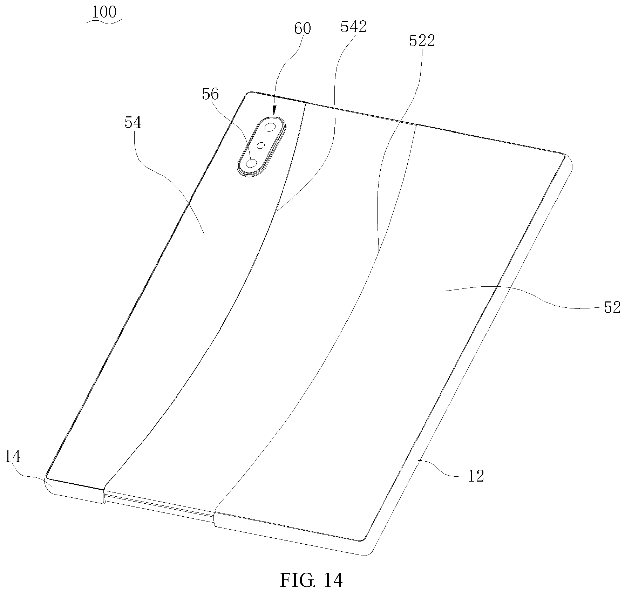

As shown in FIG. 13 and FIG. 14, it should be understood that, in some embodiments, the camera may be fixedly connected to the second portion 14 and perform the image acquisition through the second portion. Specifically, in this embodiment, the second portion 14 define a receiving space 140, the camera 60 is received in the receiving space 140, the light may pass through the second portion 14 and be received by the camera 60, such that the camera 60 may perform the image acquisition through the second portion 14. In response to the second portion 14 moving relative to the first portion 12, the camera 60 may also follow a movement of the second portion 14. In this way, the size of the flexible display screen assembly 30 may be adjusted, while a camera function may not be reduced, such that the camera 60 may be easy for the users to take pictures in any condition.

In some embodiments, the second portion 14 includes a baseplate 146, the baseplate 146 is arranged corresponding to the second portion 142, the baseplate 146 and the second portion 142 fixedly define the receiving space 140, that is, the camera 60 may be received in the receiving space 140 between the baseplate 146 and the second portion 142, such that the camera 60 may perform image acquisition through the baseplate 146 of the second portion 14. Of course, it should be understood that only a part of the camera 60 may be located in the receiving space 140 as long as the camera 60 has the normal camera function, which is not limited herein.

Further, in some embodiments, in order to ensure the normal camera function of the camera 60, the baseplate 146 may define a through hole corresponding to the camera 60, the camera 60 may be exposed from the through hole to perform the image acquisition. In some embodiments, the baseplate may include the light transmission portion corresponding to the camera 60, the camera 60 may perform the image acquisition through the light transmission portion. That is, the light may pass through the through hole or the light transmission portion to be received by the camera, the light transmission portion may be made of light transmission material such as glass.

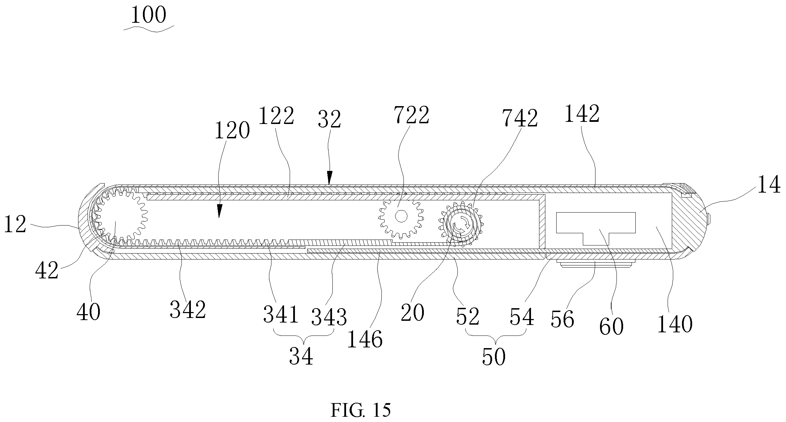

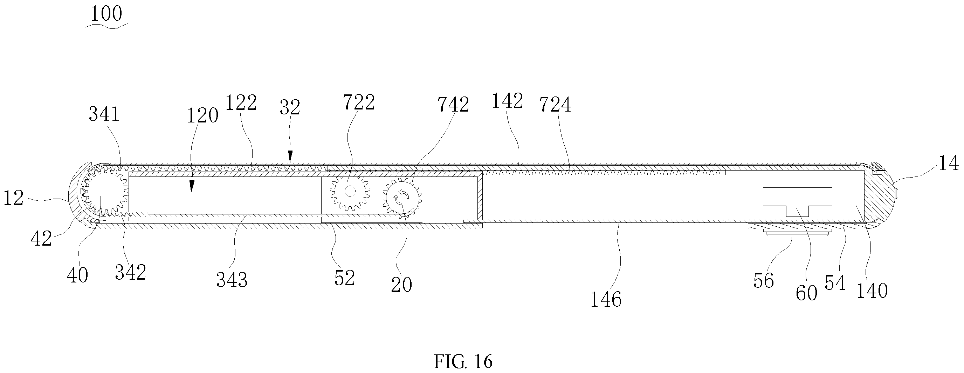

In addition, as shown in FIG. 15 and FIG. 16, in some embodiments, the cover 50 includes a first connection portion 52 and a second connection 54, the first connection portion 52 is fixedly connected to a bottom of the first portion 12 and seal the accommodating space 120, the second connection 54 is fixedly connected to a bottom of the second portion 14, the camera 60 may perform image acquisition through connecting the second connection portion 54. That is, the second connection portion 54 is fixedly connected to the first portion 12, the second connection portion 54 is fixedly connected to the second portion 14, the second connection portion 54 may move relative to the first connection portion 52, the camera 60 may follow the movement of the second portion 14.

Specifically, the second connection portion 54 may be fixedly or removably connected to the baseplate 146, the second connection portion 54 includes the light transmission portion 56 corresponding to the through hole or the light transmission portion. That is, the camera 60, the through hole (or a light transmission region), and the light transmission portion 56 is arranged according to each other, such that the camera 60 may receive the light through the through hole (or the light transmission region) to perform image acquisition.

As shown in FIG. 13 and FIG. 15, in response to the electronic apparatus 100 being in the narrow screen model, i.e., the first portion 12 and the second portion 14 move to the first extreme position, the first connection portion 52 is tiled with the second connection portion 54 to form the cover 50 of the electronic apparatus 100. As shown in FIG. 14 and FIG. 16, in response to the second portion 14 moving relative to the first portion 12, the second connection portion 54 is separated from the first connection portion 52.

Specifically, as shown in FIG. 13 and FIG. 14, in some embodiments, the first connection portion 52 define an arcuate recess 542, the second connection portion 54 is provided with a bump 522 matching the recess 542, the bump 522 is also arcuate. In response to the electronic apparatus 100 being in the narrow screen model (as shown in FIG. 13 and FIG. 15), the recess 54 is tiled with the bump 522, such that the first connection portion 52 is tiled with the second connection portion 54. It should be understood that first connection portion 52 and the second connection portion 54 may be other shape such as rectangular, such that the first connection portion 52 may be tiled with the second connection portion 54 to form the cover 50. For another example, one of the first connection portion 52 and the second connection portion 54 may be provided with bumps arranged regularly, another one may be provided with recesses matching the bumps. Therefore, in response to the electronic apparatus 100 being in the expanded model, the housing 10 has all kinds of shape to improve an aesthetic feeling.

Further, in some embodiments, the first connection portion 52 and the second connection portion 54 may be different color to enrich appearance effect.

As shown in FIG. 3, FIG. 5, and FIG. 7, in some embodiments, drive mechanism 70 may be arranged in the accommodating space 120 of the first portion 12, the drive mechanism 70 is connected to the second portion 14, the drive mechanism 70 is configured to drive the second portion 14 to move away from the first portion 12, thereby expanding the flexible display screen assembly 30.

In addition, as shown in FIG. 5 and FIG. 7, in some embodiments, the drive mechanism may be connected to the reel 20, in response to the drive mechanism 70 driving the second portion 14 to move away from the first portion 12, the drive mechanism 70 may also drive the reel 20 to rotate so as to release the flexible display screen assembly 30, thereby expanding the display portion 301 of the flexible display screen assembly 30.

Specifically, the drive mechanism 70 may include a motor 71, a first transmission mechanism 72 and a second transmission mechanism 74, the motor 71 may be fixedly arranged in the accommodating space 120 of the first portion 12. The first transmission mechanism 72 is connected to the second portion 14 and the motor 71, the second transmission mechanism 74 is connected to the first transmission mechanism 72 and the reel 20, the motor 71 is configured to drive the second portion 14 through the first transmission mechanism 72 to move to move relative to the first portion 12, and driving reel 20 through the first transmission mechanism 72 and the second transmission mechanism 74 to rotate.

The first transmission mechanism 72 includes a first transmission gear 722 and a rack 724. The first transmission gear 722 is connected to the second transmission mechanism 74 and fixed on a motor axis 711 of the motor 71, the rack 724 is fixedly connected the second portion 14, the rack 724 engages with the first transmission gear 722. Therefore, in some embodiments, driven by transmission gears and rack, a structure of the transmission gears and the rack is simple, and the transmission is simple and reliable.

Specifically, in some embodiments, the rack 724 and the second top plate 142 of the second portion 14 is formed integrally, i.e., the rack 724 may be directly formed integrally on the surface of the second top plate 142. Therefore, the rack 724 may be directly arranged at the second top plate 142 by machining, which has a good integrity and is easy to machine. It should be understood, in other embodiments, the rack 724 and the second portion 14 may also be formed separately, then the rack 724 and the second portion 14 is fixedly connected to each other by welding, which is not limited herein.

As shown in FIG. 5 and FIG. 7 again, the second transmission mechanism 74 is connected to the reel 20 and the first transmission gear 722. The second transmission mechanism 74 includes a second transmission gear 742 and a third transmission gear 744, the second transmission gear 742 is fixed on the reel 20 and concentrically arranged with the reel 20, the third transmission gear 744 is rotatably arranged on the first portion 12, and the third transmission gear 744 is connected to the second transmission gear 742 and the first transmission gear 722, i.e., the third transmission gear 744 engages with the second transmission gear 742 and the first transmission gear 722, the first transmission gear 722 and the second transmission gear 742 is located opposite two sides of the third transmission gear 744.

In some embodiments, the motor 71 may drive the second portion 14 through the first transmission mechanism 72 to move relative to the first portion 12. In addition, while the motor 71 drive the second portion 14 to move away from the first portion 12, the motor 71 may drive the reel 20 to rotate so as to release the flexible display screen assembly 30. Therefore, expanding the flexible display screen assembly 30 and releasing the reel 20 at the same tine ensure the movement stable, and the flexible display screen assembly 30 may not be easy to appear crease.

Specifically, in response to expanding a display region of the electronic apparatus 100 being in need, i.e., in response to the display portion 301 of the flexible display screen assembly 30 being expanded, the motor 71 may drive the first transmission gear 722 to rotate, the first transmission gear 722 moves away from the first portion 12 through the rack 724, the second portion 14 drives the flexible display screen assembly 30 to expand, i.e., drives the end of the flexible display screen assembly 30 to move away from the first portion 12. In addition, the first transmission gear 722 may drive the third transmission gear 744 to rotate at the same time, the third transmission gear 744 drives the reel 20 to rotate, such that the reel 20 may release the flexible display screen assembly 30, thereby expanding the display portion 301 of the flexible display screen assembly 30.

It should be understood that, reducing the display portion 301 of the flexible display screen assembly 30 may be achieved by reversing the motor 71 so as to drive the second portion 14 move away from the first portion 12. In this case, the second portion 14 gradually release the flexible display screen assembly 30, the reel may roll up the flexible display screen assembly 30. It should be understood that, in some embodiments, within unit time, a movement distance of the second portion 14 is equal to a length of the flexible display screen assembly 30 released by the rotation of the reel 20. That is, a movement distance of the flexible display screen assembly 30 driven by the second portion 14 is equal to a length of the rotation and release of the reel 20, thereby ensure the flexible display screen assembly 30 moving smoothly and without crease.

In addition, it should be understood that, in some embodiments, in order to ensure smoothly releasing and rolling up the flexible display screen assembly 30, the number of the drive mechanism 70 may be two, the number of the reel 20 may also be two, the two drive mechanism 70 may be arranged in the accommodating space 120 along a longitudinal direction of the electronic apparatus 100, the two drive mechanism 70 is respectively connected to the second portion 14, they also is respectively connected to the two reel 20. Therefore, the two drive mechanisms 70 may be concurrently driven to make the two reels 20 concurrently smoothly rotate, and make the second portion 14 move smoothly, thereby ensure the reliability of the movement of the electronic apparatus 100 in response to the display portion 301 of the flexible display screen assembly 30 being expanded

In addition, in some embodiments, the drive mechanism 70 may also include two simultaneous motors, one of the two motors is configured to drive the second portion 14 to move relative to the first portion 12, another motor drives the reel 20 to rotate, the second portion 14 and the reel 20 are respectively driven by the separate motors. Therefore, the two motors run concurrently, which also may ensure the stability and the reliability of the movement of the display portion 301 of the flexible display screen 32.

In addition, as shown in FIG. 17, in some embodiments, the drive mechanism 70 may also include the motor arranged on the first portion 12 and the first transmission mechanism 72 connected to the motor, the motor may drive the second portion 14 to move through the first transmission mechanism 72 relative to the first portion 12.

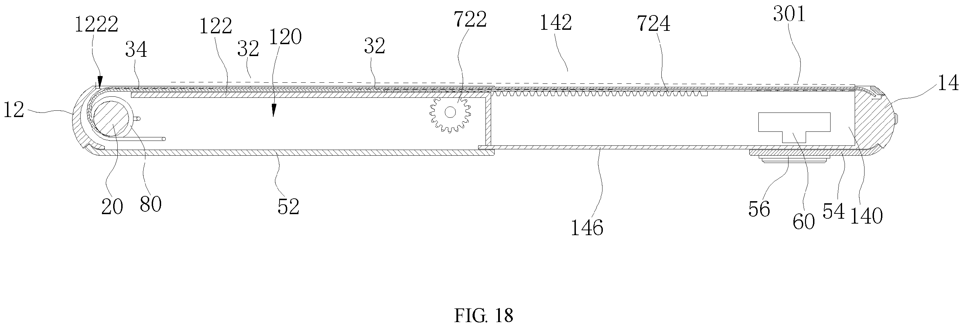

Further, as shown in FIG. 18 to FIG. 21, in some embodiments, the electronic apparatus 100 may also include a restoring mechanism 80 which may be arranged in the accommodating space 120, the restoring mechanism 80 is connected to the reel 20, the restoring mechanism 80 is configured to apply a revering force on the flexible display screen assembly 30 to make the flexible supporting member 34 keep a trend of being wound around the reel 20.

Specifically, the restoring mechanism 80 applies the revering force on the reel 20, the reel 20 which is applied the revering force may make the flexible display screen assembly 30 keep a trend of being wound around the reel 20. That is, in response to the second portion 14 being not applied on an external force and moves relative to the first portion 12, the revering force of the restoring mechanism 80 may make the reel 20 rotate, thereby making another end of the flexible display screen assembly 30 be wound around the reel 20. In this case, the first portion 12 and the second portion 14 totally match with each other, and the electronic apparatus 100 is in the narrow screen model.

In response to the second portion 14 being applied on the external force and the external force is larger than the revering force of the restoring mechanism 80, the second portion 14 moves relative to the first portion 12 so as to drive the reel 20 to overcome the external force, such that the reel 20 may rotate to release the flexible supporting member 34 of the flexible display screen assembly 30, thereby expanding the display portion 301 of the flexible display screen 32.

It should be understood that, in some embodiments, the electronic apparatus 100 includes the restoring mechanism 80, the drive mechanism 70 may also include the motor 71, the first transmission mechanism 72, and the second transmission mechanism 74 in above embodiments, the first transmission mechanism 72 is connected to a second portion of the motor 71, the second transmission mechanism 74 is connected to the first transmission mechanism 72 and the reel 20. In some embodiments, in response to the display portion 301 being in need of reducing, the motor 71 may not work, whereas the restoring force of the restoring mechanism 80 drive the reel to reverse to roll up the flexible display screen assembly 30 and drive the second portion 14 to move toward the first portion 12, i.e., move close to the first portion 12.

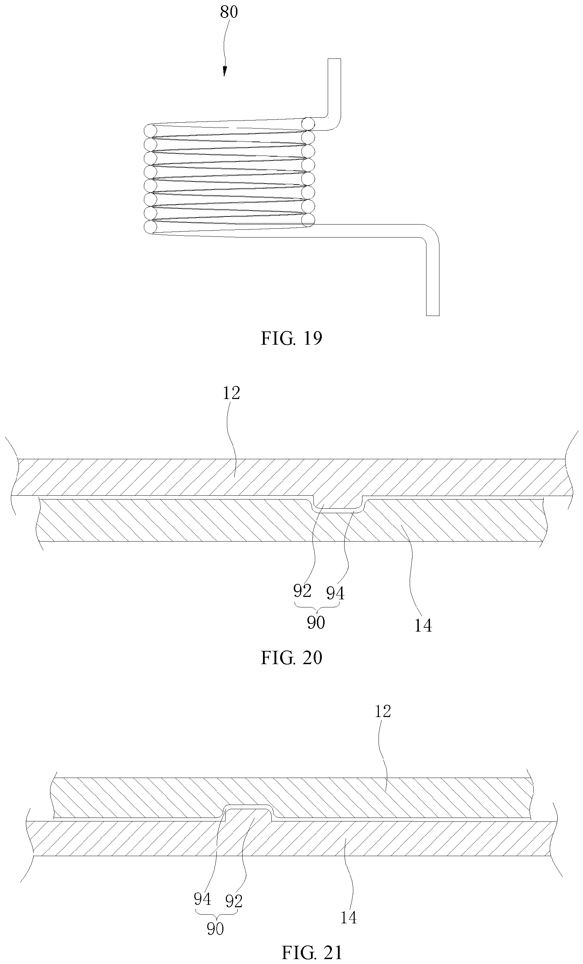

Further, as shown in FIG. 19, the restoring mechanism 80 may include an elastic component, the elastic component is connected to the reel 20 and is configured to apply a restoring force on the reel 20. The elastic component may be a spring or a torsional spring shown in FIG. 19, etc. Of course, the elastic component may be a component with an elastic restoring force such as rubber, which is not limited herein.

Further, as shown in FIG. 20, in some embodiments, the electronic apparatus 100 may also include a locking structure 90 which is arranged on the housing 10, in response to the second portion 14 moving relative to the first portion 12 to a preset position, the locking structure 90 is configured to limit the rotation of the reel 20. That is, in response to the second portion 14 moving relative to the first portion 12 to the preset position, the locking structure 90 may present the second portion 14 and the flexible display screen assembly 30 from retracting with the restoring force of the restoring mechanism 80.

Specifically, as shown in FIG. 20, in some embodiments, the locking structure 90 may include a locking block 92 arranged on the first portion 12 and the second portion 14 defines the locking groove 94, in response to the second portion 14 moving relative to the first portion 12 to the preset position, the locking block 92 engages in the locking groove 94. In this case, even if the external force on the second portion 14 is removed, since the locking block 92 engages in the locking groove 94, the second portion 14 and the flexible display screen assembly 30 may not retract with the restoring force of the restoring mechanism 80 so as to ensure the electronic apparatus 100 in the expanded model.

It should note that the preset position may be a relative position of the second portion 14 and the first portion 12 in response to the second portion 14 moving away from the first portion 12 and moves to the second extreme position. In some embodiments, the preset position may be any position before the second extreme position.

As shown in FIG. 21, it should be understood that, in some embodiments, the first portion 12 may define the locking groove 94, the locking block 92 may be arranged on the second portion 14, In addition, in some embodiments, the locking block 92 may be arranged on the first portion 12, the reel 20 defines the locking groove 94, in response to the second portion 14 moving to the preset position, the locking block 92 engages in the locking groove 94. In this case, the locking block 92 and the locking groove 94 may be engaged with each other by manually pressing or electrically driving, such that the reel 20 may not rotate relative to the first portion 12, thereby prevent the second portion 14 and the flexible display screen assembly 30 from retracting with the restoring force of the restoring mechanism 80. Of course, some embodiments, the locking structure 90 includes a locking member, the restoring mechanism 80 includes the torsional spring, in response to the second portion 14 moving to the preset position, the locking member may lock the torsional spring to work against a restoring force of the torsional spring. In addition, it should be understood that, in some embodiments, the locking structure 90 may also include an elastic assembly arranged on the first portion 12 and a first fastening portion arranged on the first portion 12, the elastic assembly may include a pressing member, the spring, and the second fastening portion, the pressing member is arranged on the first portion 12, the spring is connected to the pressing member and the first fastening portion, the pressing member may configured to drive the second fastening portion through the spring to fasten with the first fastening portion with the external force, thereby limiting the relative position of the first portion 12 and the second portion 14. In this case, in response to the second portion 14 moving to the preset portion, the users may press the pressing member to fasten the first fastening portion with the second fastening portion, thereby preventing the second portion 14 from retracting with the restoring force of the restoring mechanism 80 and make the electronic apparatus 100 in the expanded model. It should be understood that, in response to the pressing member being pressed again, the first fastening portion and the second portion separate from each other, such that the second portion 14 and the flexible display screen assembly 30 may retract with the restoring force of the restoring mechanism 80, thereby make the electronic apparatus 100 return to the expanded model.

As shown in FIG. 4 to FIG. 7, a work principle of the electronic apparatus 100 in the embodiments will be introduced below.

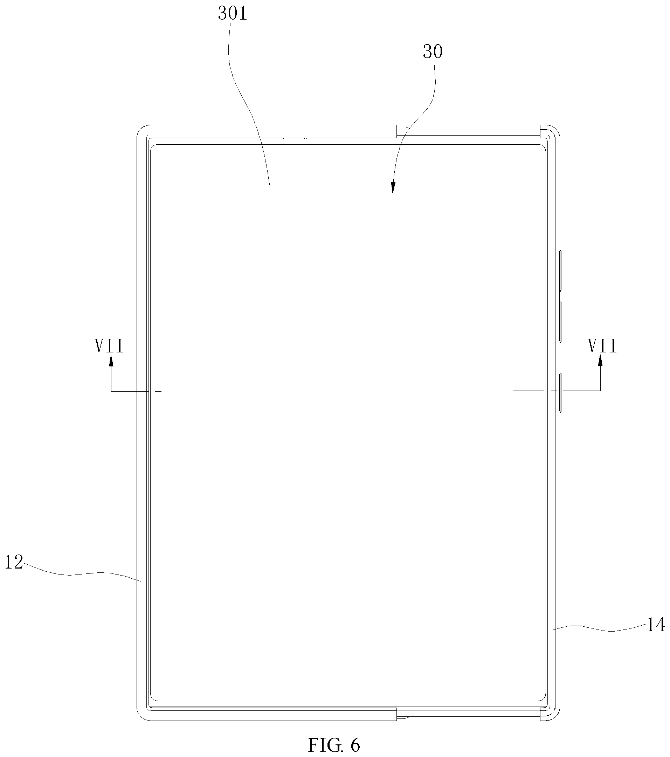

As described above, the electronic apparatus 100 may switch between the narrow screen model and the expanded model. In a state of FIG. 4 and FIG. 5, the electronic apparatus 100 is in the narrow screen model, in a state of FIG. 6 and FIG. 7, the electronic apparatus 100 is in the expanded model. In response to the electronic apparatus 100 being in the narrow screen model, the first portion 12 and the second portion 14 match with each other to form the housing 10, another end of the flexible display screen assembly 30 is wound around the reel 20, the end is connected to the second portion 14, only a small part of the flexible display screen assembly 30 is exposed from the housing 10, and the display portion 301 is narrow, which is easy for the users to carry.

In response to the users needing the larger display portion 301, they may drive the second portion 14 by the drive mechanism 70 to move away from the first portion 12. At the same time, the second portion 14 drives the flexible display screen 32 to move, the drive mechanism 70 concurrently drives the reel to rotate to release the flexible supporting member 34 of the flexible display screen assembly 30. In this case, a part of the flexible display screen assembly 30 hid in the housing is pulled out (the state is from FIG 4 to FIG. 6), thereby expanding the display portion 301 of the flexible display screen 32. In this case, the display portion 301 is larger, which may be easy to operate so as to improve the operation experience of the users

In response to the electronic apparatus 100 being need to switch from the expanded model to the narrow screen model, the motor 71 of the drive mechanism 70 may be reversed, which may drive the second portion 14 to move toward the first portion 12 so as to release the flexible display screen assembly 30. At the same time, the reel 20 is correspondingly reversed and concurrently rolls up the flexible display screen assembly 30, in response to the second portion 14 moving toward the first portion 12 and moves to the second extreme position between the first portion 12 and the second portion 14, the motor 71 stops running, and the electronic apparatus 100 returns to the narrow model.

In summary, the electronic apparatus in the embodiments of the present disclosure includes the housing 10, the reel 20 and the flexible display screen assembly 30. The housing 10 includes the first portion 12 and the second portion 14, the first portion 12 and the second portion 14 may move relative to each other. The flexible display screen assembly 30 includes the flexible display screen 32 and the flexible supporting member 34 stacked with and fixedly connected to the flexible display screen 32, the flexible display screen 32 is connected to the second portion 14, the flexible supporting member 34 is wound around the reel 20 and fixedly connected to the flexible display screen 32. In response to the first portion 12 and the second portion 14 moving away from each other, the reel 20 may rotate to release the flexible supporting member 34 of the flexible display screen assembly 30, thereby expanding the display portion 301 of the flexible display screen 32. In response to the first portion 12 and the second portion 14 moving away from each other, the flexible supporting member 34 abuts against the first portion 12 to maintain the flexible display screen 32 flat.

At present, users use mobile terminals more and more frequently, and usage scenarios are becoming increasingly diversified. Now most portable smart mobile terminals have small screen sizes, usually under 7 inches. Compared with products such as tablets, the screen display area of the portable smart mobile terminals is limited and the operation experience is limited. However, with respect to a mobile terminal with a larger screen size, for example, a mobile terminal larger than 7 inches, although the screen size is increased, the overall size of the mobile terminal is larger, which is easy to carry.

In the related art, the size of the display area is adjusted by designing the scroll-type flexible screen mobile end. Therefore, while the size of the screen can be adjusted, how to support the extended part of the screen to prevent the screen from being deformed by pressing and dislocating has become an urgent technical problem to be solved.

In the electronic apparatus 100 in the embodiments of the present disclosure, in response to the first portion 12 and the second portion 14 moving away from each other to expand the display portion 301 of a flexible display screen 32, the flexible supporting member 34 may abut against the first portion 12 to maintain an expanded portion of the flexible display screen 32 flat. In this case, the flexible supporting member 34 may abut against the first portion 12, such that the pressing deformation, the collapse and the dislocation of the flexible display screen 32 may be reduce, thereby improving the operation experience of the users.

In the description of this specification, referred terms such as "certain embodiments", "an embodiment", "some embodiments", "exemplary embodiments", "examples", "specific examples", or "some examples" means that a specific feature, structure, material, or characteristic described in combination with the embodiment or example is included in at least one embodiment or example of the present disclosure. In this specification, the schematic representation of the above-mentioned terms does not necessarily refer to the same embodiment or example. Moreover, the described specific features, structures, materials or characteristics can be combined in an appropriate manner in any one or more embodiments or examples.

Although the embodiments of the present disclosure have been shown and described above, it can be understood that the above-mentioned embodiments are exemplary and should not be construed as limiting the present disclosure. Those of ordinary skill in the art can change, modify, replace, and deform the embodiments within the scope of the present disclosure, and the scope of this disclosure is defined by the claims and their equivalents.

## Claims

1. An electronic apparatus, **characterized by** comprising:
a housing, comprising a first portion and a second portion, wherein the first portion and the second portion are movable relative to each other;
a reel, arranged on the first portion; and
a flexible display screen assembly, comprising a flexible display screen and a flexible supporting member stacked and fixedly connected to the flexible display screen; wherein the flexible display screen couples to the second portion, and the flexible supporting member winds around the reel and fixedly connected to the flexible display screen, in responses to the first portion and the second portion moving away from each other, the reel is capable of rotating to release the flexible supporting member to expand a display portion of the flexible display screen; wherein,
in response to the first portion and the second portion moving away from each other, the flexible supporting member abuts against the first portion to maintain an expanded portion of the flexible display screen flat.

2. The electronic apparatus according to claim 1, wherein the first portion comprises a first top plate arranged corresponding to the display portion of the flexible display screen, in response to the first portion and the second portion moving away from each other, the flexible supporting member is located between the flexible display screen and the first top plate.

3. The electronic apparatus according to claim 2, wherein the flexible supporting member is made of a magnetic material, the flexible supporting member is capable of being attracted on the first top plate.

4. The electronic apparatus according to claim 3, wherein the first top plate is made of a magnetic material.

5. The electronic apparatus according to claim 3, wherein the first top plate comprises a supporting layer and a magnetic layer arranged on the supporting layer, the flexible supporting member is capable of being attracted on the magnetic layer.

6. The electronic apparatus according to claim 2, wherein the second portion comprises a second top plate arranged corresponding to the first top plate, the flexible display screen comprises a first region and a second region, the first region is attached to the second top plate, the second region is attached to the flexible supporting member.

7. The electronic apparatus according to claim 6, wherein the flexible supporting member is arranged corresponding to the second region, the flexible supporting member and the flexible display screen are commonly wound around the reel.

8. The electronic apparatus according to claim 6, wherein the flexible supporting member comprises a first supporting portion and a second supporting portion connected to the first supporting portion, the first supporting portion is arranged corresponding to the second portion, the second supporting portion is wound around the reel.

9. The electronic apparatus according to claim 1, further comprising a limiter rotatably arranged on the first portion, wherein a middle portion of the flexible supporting member is wound around the limiter, and the limiter is configured to limit a shape of the flexible display screen assembly.

10. The electronic apparatus according to claim 9, wherein the first portion defines an accommodating space and a first opening communicated with the accommodating space, the limiter is arranged in the accommodating space and exposed from the first opening, a middle portion of the flexible display screen assembly passes through the first opening and is wound around the limiter.

11. The electronic apparatus according to claim 9, wherein the flexible supporting member is provided with a first teeth portion, the limiter is provided with a second teeth portion, and the second teeth portion engages with the first teeth portion.

12. The electronic apparatus according to claim 1, further comprising a drive mechanism connected to the second portion, wherein the drive mechanism is configured to drive the second portion to move away from the first portion so as to drive the flexible display screen assembly to expand, thereby expanding the display portion of the flexible display screen.

13. The electronic apparatus according to claim 12, wherein the drive mechanism comprises a motor and a first transmission mechanism connected to the motor and the second portion, the motor is configured to drive the second portion through the first transmission mechanism to move relative to the first portion.

14. The electronic apparatus according to claim 13, wherein the first transmission mechanism comprises a first transmission gear connected to the motor and a rack fixed on the second portion, the rack and the first transmission gear engage with each other.

15. The electronic apparatus according to claim 14, wherein the rack and the second portion are formed integrally.

16. The electronic apparatus according to claim 14, wherein the drive mechanism comprises a second transmission mechanism, and the second transmission mechanism is connected to the reel and the first transmission gear; the motor is configured to, while driving the second portion to move away from the first portion, drive the reel through the second transmission mechanism to rotate to release the flexible display screen assembly.

17. The electronic apparatus according to claim 16, wherein the second transmission mechanism comprises a second transmission gear and a third transmission gear, the second transmission gear is fixed on the reel, the third transmission gear is rotatably arranged on the first portion, the third transmission gear engages with the first transmission gear and the second transmission gear, the first transmission gear and the second transmission gear are respectively located at two opposite sides of the third transmission gear.

18. The electronic apparatus according to claim 1, further comprising a restoring mechanism connected to the reel, wherein the restoring mechanism is configured to apply a force on the flexible display screen assembly to make the flexible supporting member keep a trend of being wound around the reel.

19. The electronic apparatus according to claim 1, further comprising a cover, wherein the cover comprises a first connection portion and a second connection portion, the second connection portion is capable of moving relative to the first connection portion, the first connection portion is fixedly connected to the first portion, the second connection portion is fixedly connected to the second portion.

20. The electronic apparatus according to claim 1, further comprising a camera arranged on the first portion.
